# EUROPEAN PATENT APPLICATION

(11) **EP 4 576 965 A1**
(43) Date of publication of application: **25.06.2025**
(21) Application number: 23869951.6
(22) Date of filing: 25.07.2023
(51) Int. Cl.: H05K 7/20

(54) **HEAT DISSIPATION SYSTEM AND POWER APPARATUS**

(30) Priority: 28.09.2022 CN 202211193874
(71) Applicant: Huawei Digital Power Technologies Co., Ltd., Shenzhen, Guangdong 518043 (CN)
(72) Inventor: LI, Jiyang, Shenzhen, Guangdong 518043 (CN); FAN, Guohua, Shenzhen, Guangdong 518043 (CN); LIU, Zhiling, Shenzhen, Guangdong 518043 (CN); LI, Quanming, Shenzhen, Guangdong 518043 (CN)
(74) Representative: Goddar, Heinz J.
(86) International application number: PCT/CN2023/109189
(87) International publication number: WO 2024/066705

(57) **Abstract**

This application provides a heat dissipation system and a power device. The heat dissipation system may include a power module and a condenser. The power module may include a base and a power component, the base has a first chamber, and the first chamber is filled with a refrigerant. The power component is disposed on a first surface of the base, and the power component is in thermally conductive contact with the first surface. Heat generated by the power component may be transferred from the first surface to the first chamber, and is further conducted to the refrigerant, and the refrigerant may be heated and vaporized into vapor. In addition, the condenser communicates with the first chamber, and the vaporized refrigerant may enter the condenser. The refrigerant condensed into a liquid state by the condenser may flow back to the first chamber. A large amount of heat generated by the power component can be taken away through phase-change heat exchange of the refrigerant, and thermal resistance from the power module to air can be reduced. This can improve a heat dissipation capability of the power module, thereby helping improve product performance of a power device in which the heat dissipation system is used.

## Description

### CROSS-REFERENCE TO RELATED APPLICATIONS

This application claims priority to Chinese Patent Application No. 202211193874.4, filed with the China National Intellectual Property Administration on September 28, 2022 and entitled "HEAT DISSIPATION SYSTEM AND ELECTRONIC DEVICE", which is incorporated herein by reference in its entirety.

### TECHNICAL FIELD

This application relates to the field of heat dissipation technologies, and in particular, to a heat dissipation system and a power device.

### BACKGROUND

With development of electronic technologies, high-power semiconductor devices are increasingly widely used in the power electronics industry. Because a computing capability of the high-power semiconductor device is continuously improved, power consumption of the high-power semiconductor device also increases greatly. Consequently, the high-power semiconductor device generates more heat, and heat flow density is increasing. This poses a huge challenge to heat dissipation of the high-power semiconductor device.

Currently, a power device develops towards miniaturization and integration, and leaves little space for disposing a heat dissipation assembly. However, if there is no good heat dissipation measure for the high-power semiconductor device, a use environment of the high-power semiconductor device is limited, and product performance is also limited. Therefore, a heat dissipation capability of the high-power semiconductor device at high power density needs to be improved urgently.

### SUMMARY

This application provides a heat dissipation system and a power device, to improve a heat dissipation capability of a power module, thereby improving product performance of a power device in which the heat dissipation system is used.

According to a first aspect, this application provides a heat dissipation system. The heat dissipation system may include a power module and a condenser. The power module may include a base and a power component, the base has a first chamber, and the first chamber is filled with a refrigerant. The refrigerant may be heated and vaporized into vapor, and the vapor may be cooled and condensed into the liquid refrigerant. The power component may be disposed on a first surface of the base, and the power component is in thermally conductive contact with the first surface. In addition, the condenser communicates with the first chamber, and the condenser may be configured to condense the gaseous refrigerant into the liquid refrigerant.

According to the heat dissipation system provided in this application, when the power module works, heat may be conducted from the power component to the first surface of the base, and may be further conducted to the liquid refrigerant in the first chamber of the base. The liquid refrigerant is heated and vaporized to form the vapor. The vapor enters the condenser, and flows back to the first chamber after the vapor is condensed into a liquid state. It can be understood that, in the foregoing refrigerant phase-change process, a large amount of heat generated by the power component may be taken away, to perform heat dissipation for the power component. In addition, phase-change heat exchange of the refrigerant can be used to effectively reduce thermal resistance from the power module to air, thereby effectively improving a heat dissipation capability of the power module.

In a possible implementation of this application, the refrigerant in the first chamber may flow back to the first chamber under an action of gravity after the refrigerant is condensed into the liquid state by the condenser. In this way, without being driven by a pump or another power device, the refrigerant in the first chamber can enter the condenser after being vaporized, and the refrigerant condensed into the liquid refrigerant through the condenser can flow back to the first chamber under the action of gravity, thereby implementing efficient cycling of the refrigerant between the base and the condenser.

In this application, a placement manner of the heat dissipation system is not limited, and the heat dissipation system may be placed based on a specific application scenario. For example, the heat dissipation system may be placed in a gravity direction. The gravity direction may be defined as a direction from the top to the bottom when a device in which the heat dissipation system is used is in a normal use state and is placed in a customary manner in the art. For example, when the heat dissipation system is used in a photovoltaic inverter, and the photovoltaic inverter is in the normal use state, the gravity direction may be understood as a direction from the top to the bottom of the photovoltaic inverter. In this case, the heat dissipation system is placed in the direction from the top to the bottom of the photovoltaic inverter.

In addition, when the heat dissipation system is placed in the gravity direction, the condenser may be located above the base. Based on this, when the base is placed, in a possible implementation, a thickness direction of the base may be perpendicular to the gravity direction.

Because the first surface of the base may be configured to dispose the power component, in a possible implementation of this application, the thickness direction of the base may be further perpendicular to the first surface. In this case, the first surface is parallel to the gravity direction.

In this application, a flow nozzle may be disposed on the base, and the flow nozzle communicates with the first chamber. In addition, the flow nozzle may be disposed on a second surface of the base, and the second surface and the first surface are disposed away from each other. This helps simplify a structure of the base. In a possible implementation, the condenser may communicate with the first chamber through the flow nozzle, so that a connection between the condenser and the base is convenient.

Because cycling of the refrigerant between the power module and the condenser needs to undergo a liquid-to-gas state transition and a gas-to-liquid state transition, to distinguish a gas flowing path from a liquid flowing path, at least two flow nozzles may be disposed on the base. In this way, at least one of the flow nozzles can be connected to the condenser through a first liquid flowing pipeline, and at least one of the flow nozzles is connected to the condenser through a first gas flowing pipeline.

In a possible implementation of this application, the heat dissipation system may further include an evaporator. The evaporator has a second chamber, and the second chamber is filled with a refrigerant. In addition, the condenser may communicate with the first chamber through the second chamber. Specifically, the second chamber may communicate with the first chamber through the flow nozzle, and the second chamber may communicate with the condenser. In this way, the refrigerant in the second chamber can be replenished to the first chamber in time, so that a region that is of the base and that is used to dispose the power component can always be in contact with the refrigerant. This helps improve efficiency of heat exchange between the power component and the refrigerant, thereby improving the heat dissipation capability of the power module.

When the flow nozzle is connected to the evaporator, the evaporator may be provided with through holes, and the flow nozzles may be connected to the through holes in a one-to-one correspondence. In a possible implementation, the flow nozzle may be directly inserted into the through hole, and the flow nozzle is fastened to the evaporator. A fastening manner of the flow nozzle may be but is not limited to welding, bonding, or the like. In this way, a connection manner between the flow nozzle and the evaporator can be simplified, and a structure of the heat dissipation system can be compact.

To ensure sealing between the flow nozzle and the through hole, a sealing ring may be further disposed between the flow nozzle and the through hole. The sealing ring is sleeved on the flow nozzle, and a sidewall of the through hole may press the sealing ring, so that the sealing ring fills a gap between the flow nozzle and the through hole.

In another possible implementation, the flow nozzle may be connected to the through hole through a pipeline. During specific implementation, at least two flow nozzles may be disposed on the base, at least one of the flow nozzles is connected to the corresponding through hole through a second liquid flowing pipeline, and at least one of the flow nozzles is connected to the corresponding through hole through a second gas flowing pipeline.

In this application, the evaporator may also be connected to the condenser through a pipeline. For example, the evaporator may be connected to the condenser through at least one first liquid flowing pipeline and at least one first gas flowing pipeline, so that a gas flowing path and a liquid flowing path in which the refrigerant cycles between the evaporator and the condenser can be distinguished.

In a possible implementation of this application, the refrigerant in the second chamber may flow back to the second chamber under an action of gravity after the refrigerant is condensed into the liquid state by the condenser. In this way, without being driven by a pump or another power device, the refrigerant in the second chamber can enter the condenser after being vaporized, and the refrigerant condensed into the liquid refrigerant through the condenser can flow back to the second chamber under the action of gravity, thereby implementing efficient cycling of the refrigerant between the evaporator and the condenser.

In this application, a placement manner of the heat dissipation system is not limited, and the heat dissipation system may be placed based on a specific application scenario. For example, the heat dissipation system may be placed in a gravity direction. The gravity direction may be defined as a direction from the top to the bottom when a device in which the heat dissipation system is used is in a normal use state and is placed in a customary manner in the art. For example, when the heat dissipation system is used in a photovoltaic inverter, and the photovoltaic inverter is in the normal use state, the gravity direction may be understood as a direction from the top to the bottom of the photovoltaic inverter. In this case, the heat dissipation system is placed in the direction from the top to the bottom of the photovoltaic inverter.

In addition, when the heat dissipation system is placed in the gravity direction, the condenser may be located above the evaporator. Based on this, when the base is placed, in a possible implementation, a thickness direction of the base may be perpendicular to the gravity direction.

Because the first surface of the base may be configured to dispose the power component, in a possible implementation of this application, the thickness direction of the base may be further perpendicular to the first surface. In this case, the first surface is parallel to the gravity direction.

In a possible implementation of this application, each first chamber communicates with respective second cavities of at least two evaporators. At least one of the evaporators is connected to the condenser through a first liquid flowing pipeline, and at least one of the evaporators is connected to the condenser through a first gas flowing pipeline. In this way, the refrigerant may cycle between the power module, the at least one evaporator connected to the condenser through the first liquid flowing pipeline, the at least one evaporator connected to the condenser through the first gas flowing pipeline, and the condenser. Specifically, after the liquid refrigerant in the first chamber is evaporated into a gas state, the gaseous refrigerant may enter the condenser after passing through a second chamber of the at least one evaporator connected to the condenser through the first gas flowing pipeline. The refrigerant condensed into the liquid state by the condenser may flow back to a second chamber of the at least one evaporator connected to the condenser through the first liquid flowing pipeline. Refrigerants in the second chambers may be used to replenish the refrigerant in the first chamber. Therefore, each power module is connected to the at least two evaporators, so that the refrigerant in the first chamber can be replenished in time, thereby helping improve heat dissipation efficiency of the power module.

In addition, in the at least two evaporators connected to the first chamber of each power module, at least one evaporator may be connected to the condenser through at least one liquid flowing pipeline and at least one gas flowing pipeline. In this way, the refrigerant may cycle between the power module, the at least one evaporator connected to the condenser through the at least one liquid flowing pipeline and the at least one gas flowing pipeline, and the condenser. It may also be understood that at least one of cycling paths of the refrigerant includes the power module, the evaporator, and the condenser. For the cycling path, after the liquid refrigerant in the first chamber is evaporated into the gas state, the gaseous refrigerant may enter the condenser after passing through the second chamber of the evaporator. The refrigerant condensed into the liquid state by the condenser may flow back to the second chamber of the evaporator. The refrigerant in the second chamber may be used to replenish the refrigerant in the first chamber.

When each power module is specifically connected to the at least two evaporators, the at least two flow nozzles may be disposed on each power module. In this way, each flow nozzle may be connected to at least one evaporator. For example, one flow nozzle may be connected to two evaporators. Alternatively, when a quantity of evaporators is the same as a quantity of flow nozzles, the flow nozzles may be connected to the evaporators in a one-to-one correspondence. In addition, when each flow nozzle is connected to the at least one evaporator, two flow nozzles may be connected to one evaporator. For example, when the evaporator is connected to the condenser through the at least one first liquid flowing pipeline and the at least one first gas flowing pipeline, the two flow nozzles may be connected to the evaporator, to form a refrigerant cycling path between the power module, the evaporator, and the condenser. It should be understood that they all fall within the protection scope of this application.

In this application, each evaporator may be further connected to at least two power modules. This helps implement an integrated design of the heat dissipation system.

To improve the heat dissipation efficiency of the power module, in a possible implementation of this application, a heat dissipation enhancement structure may be further disposed on the base. During specific implementation, the base further has a first inner side surface, the first inner side surface and the first surface are disposed away from each other, and at least a part of the first inner side surface is immersed in the refrigerant. After the heat generated by the power component is conducted from the first surface of the base to the first inner side surface, the heat may be directly transferred to the refrigerant, to implement efficient heat exchange between the base and the refrigerant.

In addition, the heat dissipation enhancement structure may be disposed on the first inner side surface, the heat dissipation enhancement structure is disposed in a heat dissipation enhancement region of the first inner side surface, and the heat dissipation enhancement structure may be configured to increase an area of the first inner side surface immersed in the refrigerant. In this way, in a direction from the first surface to the first inner side surface, at least a part of projection of the power component on the first inner side surface may be located in the heat dissipation enhancement region, so that heat exchange can be efficiently performed between the heat generated by the power component and the refrigerant, to help improve heat dissipation performance of the power module.

In this application, a specific disposing form of the heat dissipation enhancement structure is not limited. For example, the heat dissipation enhancement structure may be a groove or a protrusion located on the second surface, or may be a fin or a capillary structure, so that the area of the base immersed in the refrigerant can be increased.

According to a second aspect, this application further provides a power device. The power device may include a chassis and the heat dissipation system according to the first aspect. The evaporator may be located inside or outside the chassis, and the condenser is located outside the chassis. In this application, a specific type of the power device is not limited, and the power device may be but is not limited to a photovoltaic power generation device like a photovoltaic inverter. The power device has a strong heat dissipation capability, so that product performance of the power device can be improved, thereby improving product competitiveness of the power device.

### BRIEF DESCRIPTION OF DRAWINGS

FIG. 1 is a diagram of a structure of a power module according to an embodiment of this application;
FIG. 2a to FIG. 2g are diagrams of structures of several first inner side surfaces according to an embodiment of this application;
FIG. 3 is a three-dimensional diagram of the power module shown in FIG. 1;
FIG. 4 is a sectional view of the power module shown in FIG. 3;
FIG. 5 is a diagram of a structure of a heat dissipation system according to an embodiment of this application;
FIG. 6 is a diagram of a structure of another heat dissipation system according to an embodiment of this application;
FIG. 7 is a cross-sectional view of a connection position of a power module and an evaporator shown in FIG. 6;
FIG. 8a to FIG. 8c are diagrams of heat dissipation principles of the heat dissipation system shown in FIG. 6;
FIG. 9 is a diagram of a structure of another heat dissipation system according to an embodiment of this application;
FIG. 10 is a diagram of a structure of another heat dissipation system according to an embodiment of this application;
FIG. 11 is a diagram of a structure of another heat dissipation system according to an embodiment of this application; and
FIG. 12 is a diagram of a structure of a power device according to an embodiment of this application.

### Reference numerals:

1: power module; 101: power component; 102: base; 1021: first surface; 1022: first chamber;
1023: first inner side surface; 10231: heat dissipation enhancement region; 1024: fin; 1025: capillary structure; 1026: flow nozzle;
1027: second surface; 2: condenser; 3: first liquid flowing pipeline; 4: first gas flowing pipeline; 5: evaporator;
501: second chamber; 502: through hole; 6: second liquid flowing pipeline; 7: second gas flowing pipeline; and 8: chassis.

### DESCRIPTION OF EMBODIMENTS

Terms used in the following embodiments are merely intended to describe particular embodiments, but are not intended to limit this application. The singular expression "one", "a/an", "said", "the foregoing", "the", and "this" as used in this specification and the appended claims of this application are also intended to include expressions such as "one or more", unless otherwise specified in the context clearly. Reference to "an embodiment", "a specific embodiment", or the like described in this specification means that one or more embodiments of this application include a specific feature, structure, or characteristic described with reference to the embodiment. The terms "include", "contain", "have", and their variants all mean "include but are not limited to", unless otherwise specifically emphasized.

To facilitate understanding of a heat dissipation system and a power device provided in embodiments of this application, the following first describes an application scenario of the heat dissipation system and the power device. The heat dissipation system provided in this application may be used in, but is not limited to, a power device like a photovoltaic inverter. With development of electronic technologies, more heat dissipation requirements are posed on high-power semiconductor devices in power devices. For example, in the photovoltaic inverter, heat flow density of an insulated gate bipolar transistor (IGBT) is increasingly high. A good heat dissipation measure helps improve a maximum current output capability of the insulated gate bipolar transistor, thereby improving performance of the photovoltaic inverter and improving product competitiveness.

For improvement of power density of the high-power semiconductor device, currently, heat dissipation enhancement research on the high-power semiconductor device is very extensive. Heat dissipation modes mainly include air cooling, natural cooling, and liquid cooling, and a specific heat dissipation mode is selected based on an actual application scenario. For example, the photovoltaic inverter is mainly used in an outdoor scenario, and the air cooling is a main heat dissipation form of the photovoltaic inverter. For air-cooled heat dissipation, the high-power semiconductor device is usually attached to a surface of an air-cooled heat sink via thermally conductive silicone grease for heat dissipation. Currently, heat dissipation enhancement research on the air-cooled heat dissipation is mainly a solution in which a heat pipe heat sink or a vapor chamber (VC) heat sink is added on a basis of a common aluminum air-cooled heat sink, and the like. However, a bottleneck is encountered in future evolution. In addition, based on distribution of thermal resistance of a heat dissipation link, thermal resistance of a thermally conductive silicone grease layer accounts for 20%. Currently, there is no good alternative solution for reducing the thermal resistance.

Based on this, this application provides a heat dissipation system and a power device, to remove the silicone grease layer from the heat dissipation link by directly contacting a heat dissipation surface of a power module with a refrigerant, and reduce thermal resistance from the module to air through efficient phase-change heat exchange, thereby improving a heat dissipation capability of the power module. This helps improve product performance of a power device in which the heat dissipation system is used, and improve product competitiveness. To make the objectives, technical solutions, and advantages of this application clearer, the following further describes this application in detail with reference to the accompanying drawings.

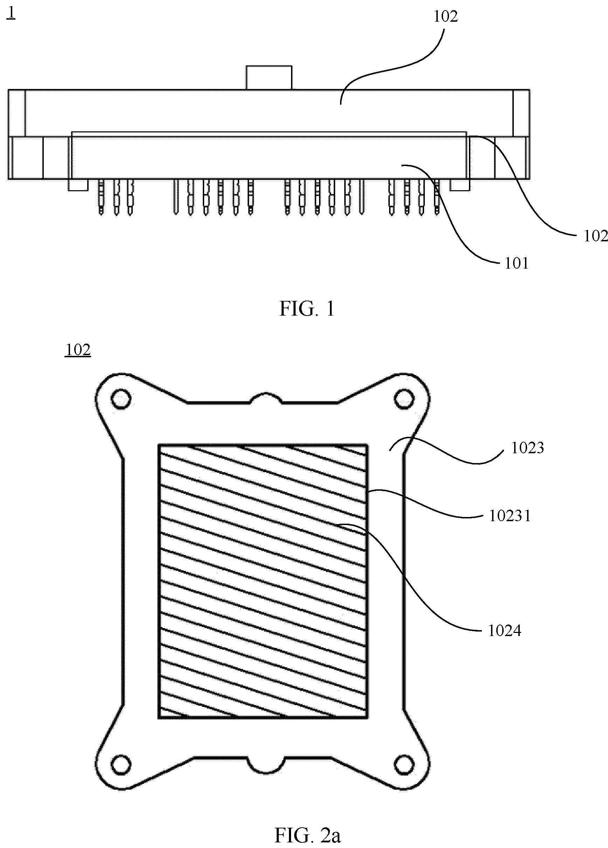

In this application, the heat dissipation system may include a power module. FIG. 1 is a diagram of a structure of a power module 1 according to an embodiment of this application. The power module 1 includes a power component 101 and a base 102. The power component 101 may be but is not limited to a chip, a database controller (DBC), or the like. The power component 101 may be disposed on a first surface 1021 of the base 102, and the power component 101 is in thermally conductive contact with the first surface 1021 of the base 102. In addition, one or more power components 101 may be disposed on each base 102, and a quantity of the power components may be disposed based on a specific application scenario of the power module 1.

In this application, a material of the base 102 is not limited. For example, the base 102 may be a metal with good thermal conductivity like copper or aluminum. In some possible embodiments, the material of the base 102 may alternatively be a non-metal with good thermal conductivity. When the base 102 is specifically disposed, the base 102 has a first chamber (not shown in FIG. 1), the first chamber is filled with a refrigerant, and the refrigerant is a vapor-liquid two-phase refrigerant. In other words, when a temperature is less than or equal to a first temperature threshold, the refrigerant is in a liquid state. When the temperature is higher than the first temperature threshold, the refrigerant boils and changes to vapor through phase change. A specific type of the refrigerant is not limited in this application. For example, the refrigerant may be tetrafluoroethane (1, 1, 1, 2-tetrafluoroethane) or the like. It can be understood that the first temperature threshold is affected by a type of the refrigerant, and may be, for example, 20°C or 25°C.

It can be understood that, in this application, projection of the power component 101 on the base 102 can completely fall within a contour range of the first surface 1021, so that a contact area between the power component 101 and the first surface 1021 can be effectively increased. This helps improve efficiency of heat exchange between the power component 101 and the refrigerant in the base 102, and further improve heat dissipation performance of the power module 1.

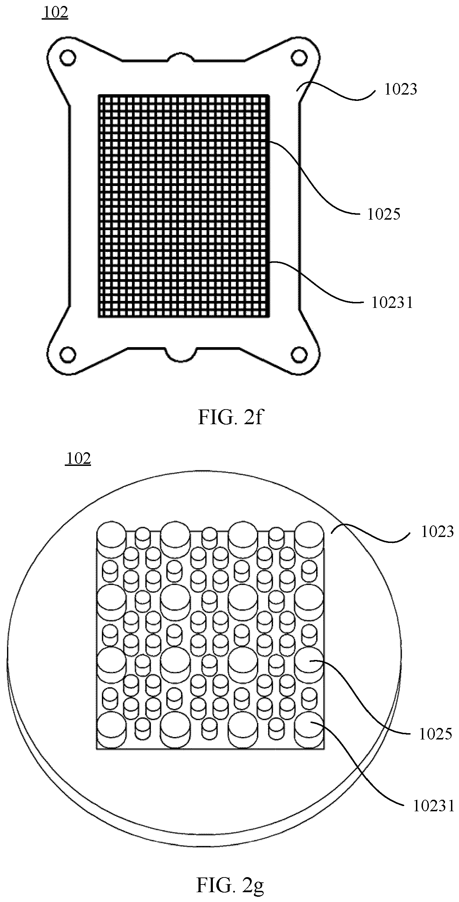

In addition, to improve efficiency of transferring heat from the power component 101 to the refrigerant, a heat dissipation enhancement structure may be further disposed on the base 102. For example, the heat dissipation enhancement structure may be disposed on a first inner side surface 1023 of the base 102. The first inner side surface 1023 and the first surface 1021 are disposed away from each other, and at least a part of the first inner side surface 1023 is immersed in refrigerant. When the heat dissipation enhancement structure is specifically disposed, refer to FIG. 2a. FIG. 2a is a diagram of a structure of the first inner side surface 1023 of the base 102 according to an embodiment of this application. The heat dissipation enhancement structure may be a fin 1024 formed on the first inner side surface 1023, and the fin 1024 may increase an area of the first inner side surface 1023 immersed in the refrigerant. In this application, the fin 1024 may be a protrusion structure formed on the first inner side surface 1023, and the fin 1024 and the first inner side surface 1023 may be of an integrally formed structure. Alternatively, the fin 1024 may be of an independently formed structure, and may be fastened to the first inner side surface 1023 in a possible manner like welding. The fin 1024 may be disposed in a heat dissipation enhancement region 10231 of the first inner side surface 1023. In addition, in a direction from the first surface to the first inner side surface 1023, at least a part of projection of the power component 101 on the first inner side surface 1023 may be located in the heat dissipation enhancement region 10231. Because the first inner side surface 1023 is in direct contact with the refrigerant in the first chamber 1022, the fin 1024 is disposed on the first inner side surface 1023, so that the area of the first inner side surface 1023 immersed in the refrigerant can be effectively increased. In this way, heat generated by the power component 101 can be efficiently exchanged with the refrigerant, and this helps improve the heat dissipation performance of the power module 1.

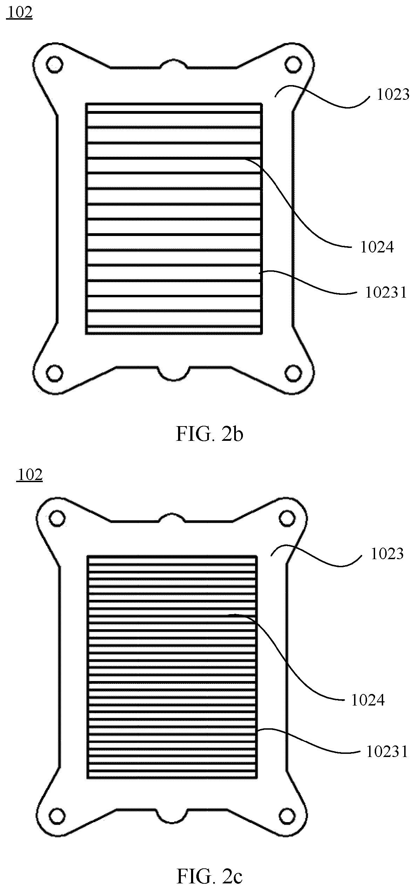

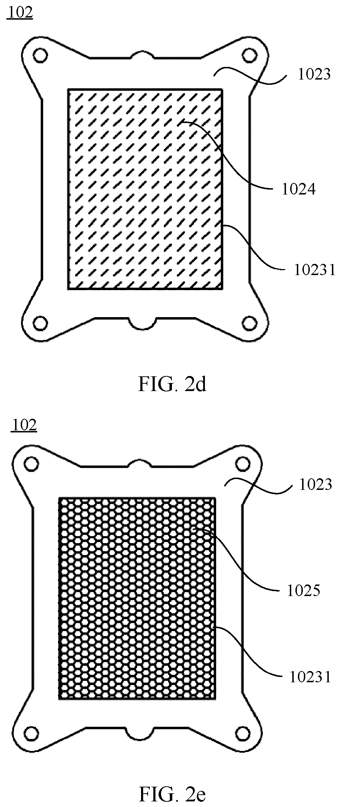

In this application, there may be a plurality of fins 1024 disposed in parallel. In the embodiment shown in FIG. 2a, the plurality of fins 1024 are disposed obliquely. In addition, the fins 1024 may be disposed in a possible form other than the manner shown in FIG. 2a. For example, refer to FIG. 2b to FIG. 2d. FIG. 2b to FIG. 2d show several possible disposing forms of the fins 1024. For example, in FIG. 2b and FIG. 2c, there may be a plurality of fins 1024 disposed in parallel, and the plurality of fins 1024 are disposed in parallel with one side of the first inner side surface. For another example, in an embodiment shown in FIG. 2d, there are a plurality of rows of fins 1024 disposed in parallel, each row includes a plurality of fins 1024, and the plurality of rows of fins 1024 are disposed obliquely.

In addition, in this application, the heat dissipation enhancement structure may be disposed as a possible structure other than the fins 1024 shown in FIG. 2a to FIG. 2d. For example, refer to FIG. 2e to FIG. 2g. FIG. 2e to FIG. 2g are diagrams of structures of other several first inner side surfaces 1023 according to an embodiment of this application. FIG. 2g is a diagram of a three-dimensional structure of the first inner side surface 1023. In FIG. 2e to FIG. 2g, the heat dissipation enhancement structure may be a capillary structure 1025. The capillary structure 1025 may be but is not limited to a metal mesh structure, a metal powder sintering structure, or the like, and adsorbs liquid. The capillary structure 1025 may alternatively be disposed in the heat dissipation enhancement region 10231 of the first inner side surface 1023, so that the area of the first inner side surface 1023 immersed in the refrigerant can be effectively increased.

It should be noted that a shape of the first inner side surface 1023 is not specifically limited in this application, and may be a rectangle-like shape shown in FIG. 2a to FIG. 2f, or may be a circle shown in FIG. 2g, or may be another possible regular shape or irregular shape. In some other possible embodiments of this application, the heat dissipation enhancement structure may alternatively be a groove or a protrusion located on the first inner side surface 1023, provided that the area of the first inner side surface 1023 immersed in the refrigerant can be increased.

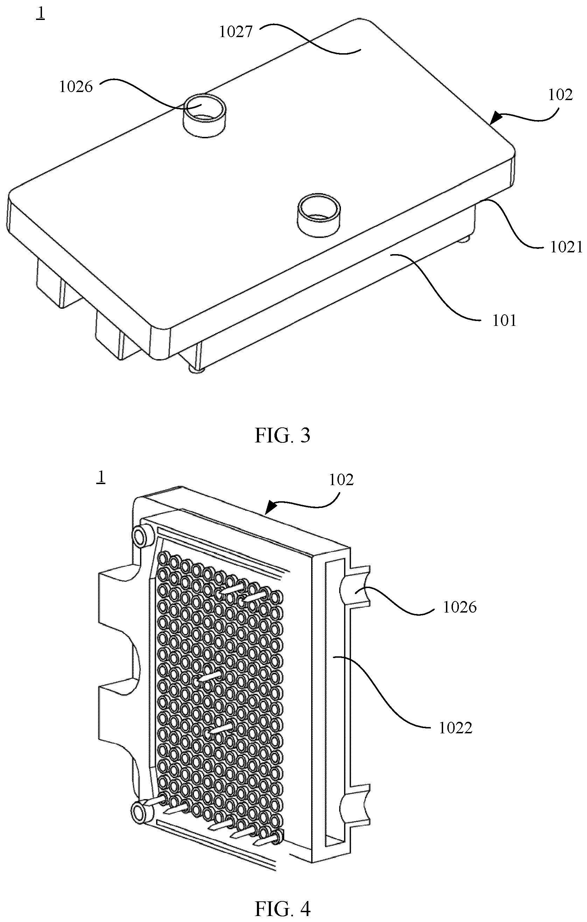

FIG. 3 is a three-dimensional diagram of the power module 1 shown in FIG. 1. A flow nozzle 1026 may be further disposed on the base 102, and the flow nozzle 1026 is disposed on a second surface 1027 of the base 102. In addition, the flow nozzle 1026 may protrude from the second surface 1027. In a possible embodiment of this application, the base 102 may be of an integrally formed structure, so that a structure of the base 102 can be simplified, and the base 102 has good sealing performance. In some other possible embodiments of this application, the flow nozzle 1026 of the base 102 may alternatively be of an independently formed structure, and may be connected to the second surface 1027 of the base 102 through welding, bonding, or the like. Therefore, the flow nozzle 1026 is disposed more flexibly.

In this application, a location relationship between the first surface 1021 and the second surface 1027 is not limited. For example, in an embodiment shown in FIG. 3, the first surface 1021 and the second surface 1027 may be disposed away from each other. In some other possible embodiments of this application, the first surface 1021 and the second surface 1027 may alternatively be two adjacent surfaces.

FIG. 4 is a sectional view of the power module 1 shown in FIG. 3. It can be learned from FIG. 4 that the flow nozzle 1026 communicates with the first chamber 1022, and the flow nozzle 1026 may be used as a channel through which the refrigerant flows into and out of the first chamber 1022. In this application, a quantity of flow nozzles 1026 is not specifically limited. For example, in embodiments shown in FIG. 3 and FIG. 4, two flow nozzles 1026 may be disposed on the base 102. One of the two flow nozzles 1026 may be used by the refrigerant to enter the first chamber 1022, and the other flow nozzle may be used by the refrigerant to flow out of the first chamber 1022. In another possible embodiment of this application, only one flow nozzle 1026 may alternatively be disposed on the base 102. The flow nozzle 1026 may be used by the refrigerant to enter the first chamber 1022, and may also be used by the refrigerant to flow out of the first chamber 1022. In some other possible embodiments of this application, more than two flow nozzles 1026 may alternatively be disposed on the base 102, for example, three, four, or five flow nozzles. At least one of the more than two flow nozzles 1026 may be used by the refrigerant to enter the first chamber 1022, and the other flow nozzles 1026 may be used by the refrigerant to flow out of the first chamber 1022.

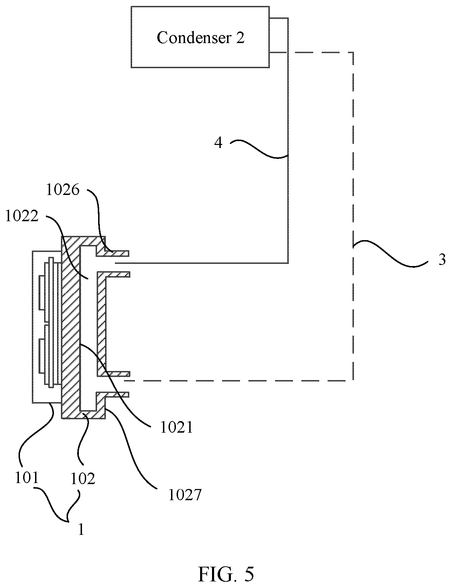

FIG. 5 is a diagram of a structure of a heat dissipation system according to an embodiment of this application. In addition to the power module 1, the heat dissipation system may further include a condenser 2, and the first chamber 1022 of the base 102 communicates with the condenser 2. During specific implementation, the flow nozzle 1026 of the base 102 may be connected to the condenser 2. Because the flow nozzle 1026 may protrude from the second surface 1027, the flow nozzle 1026 can be conveniently connected to the condenser 2. In addition, the flow nozzle 1026 may be connected to the condenser 2 through a pipeline, but this is not limited. The pipeline may be a hose, so that the flow nozzle 1026 is more conveniently connected to the condenser 2. In some possible application scenarios, for example, when space for disposing the heat dissipation system is large, the flow nozzle 1026 may alternatively be connected to the condenser 2 through a rigid tube.

According to the heat dissipation system provided in this application, when the power module 1 works, the heat may be conducted from the power component 101 to the first surface 1021 of the base 102, and may be further conducted to the liquid refrigerant in the first chamber 1022 of the base 102. The liquid refrigerant is heated and vaporized to form the vapor. The vapor enters the condenser 2 through the flow nozzle 1026, and flows back to the first chamber 1022 after the vapor is condensed into the liquid state. It may be understood that, in the foregoing refrigerant phase-change process, a large amount of heat generated by the power component 101 may be taken away, to perform heat dissipation for the power component 101. In addition, phase-change heat exchange of the refrigerant can be used to effectively reduce thermal resistance from the power module 1 to air, thereby effectively improving a heat dissipation capability of the power module 1.

Because cycling of the refrigerant between the power module 1 and the condenser 2 needs to undergo a liquid-to-gas state transition and a gas-to-liquid state transition, to distinguish a gas flowing path from a liquid flowing path, at least two flow nozzles 1026 may be disposed on the base 102. In this case, at least one of the flow nozzles 1026 can be connected to the condenser 2 through a liquid flowing pipeline, and at least one of the flow nozzles 1026 is connected to the condenser 2 through a gas flowing pipeline. For example, in FIG. 5, a dashed line represents a first liquid flowing pipeline 3 configured to connect the flow nozzle 1026 and the condenser 2, and a solid line represents a first gas flowing pipeline 4 configured to connect the flow nozzle 1026 and the condenser 2. In this way, the vapor formed by the refrigerant may enter the condenser 2 through the at least one flow nozzle 1026, and the liquid refrigerant condensed through the condenser 2 flows back to the first chamber 1022 through the at least one flow nozzle 1026. In this way, the refrigerant efficiently cycles between the power module 1 and the condenser 2. In some possible embodiments of this application, only one flow nozzle 1026 may alternatively be disposed on the base 102, so that the base 102 is connected to the condenser 2 through the flow nozzle 1026, thereby simplifying a structure of the power module 1.

In this application, the refrigerant condensed into the liquid state by the condenser 2 can flow back to the first chamber 1022. Based on this, when the condenser 2 and the base 102 are arranged, the condenser 2 and the base 102 of the power module 1 may be arranged in a gravity direction. For example, in the gravity direction, the condenser 2 may be located above the base 102. The condenser 2 and the base 102 may be arranged along a straight line in the gravity direction, or may be staggered in the gravity direction. In this way, without being driven by a pump or another power device, the refrigerant in the first chamber 1022 can enter the condenser 2 after being vaporized, and the refrigerant condensed into the liquid refrigerant through the condenser 2 can flow back to the first chamber 1022 under an action of gravity, thereby implementing efficient cycling of the refrigerant between the base 102 and the condenser 2.

In embodiments of this application, when the heat dissipation system is placed in the gravity direction, the gravity direction may be defined as a direction from the top to the bottom when a device in which the heat dissipation system is used is in a normal use state and is placed in a customary manner in the art. For example, when the heat dissipation system is used in a photovoltaic inverter, and the photovoltaic inverter is in the normal use state, the gravity direction may be understood as a direction from the top to the bottom of the photovoltaic inverter. In this case, the heat dissipation system is placed in the direction from the top to the bottom of the photovoltaic inverter.

In this application, when the heat dissipation system is placed in the gravity direction, a thickness direction of the base 102 may be perpendicular to the gravity direction. In addition, the thickness direction of the base 102 may be perpendicular to the first surface 1021. In this case, the first surface 1021 is parallel to the gravity direction.

In addition, the base 102 and the condenser 2 each may be disposed in any direction, and may be adjusted based on a specific application scenario. This is not specifically limited in this application, provided that the liquid refrigerant condensed through the condenser 2 can flow back to the first chamber 1022.

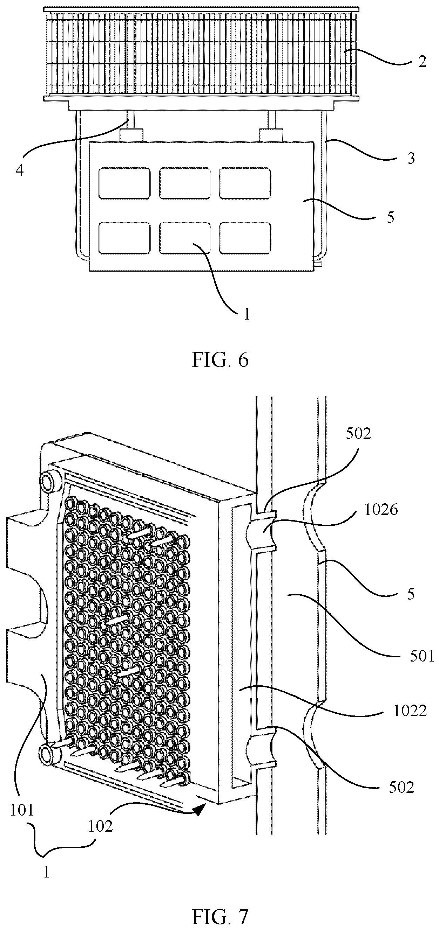

FIG. 6 is a diagram of a structure of another heat dissipation system according to an embodiment of this application. In addition to the power module 1 and the condenser 2, the heat dissipation system may further include an evaporator 5. The evaporator 5 has a second chamber 501, and the second chamber 501 is filled with a refrigerant.

In the embodiment shown in FIG. 6, the base 102 may be connected to the condenser 2 via the evaporator 5. During specific implementation, refer to FIG. 7. FIG. 7 is a cross-sectional view of a connection position of the power module 1 and the evaporator 5 shown in FIG. 6. The evaporator 5 may be provided with through holes 502, and the flow nozzles 1026 may be connected to the through holes 502 in a one-to-one correspondence, so that the first chamber 1022 of the base 102 communicates with the second chamber 501 of the evaporator 5. It may be understood that the refrigerant in the first chamber 1022 may be the same as the refrigerant in the second chamber 501, so that the refrigerant in the second chamber 501 can be replenished to the first chamber 1022 in time. In this way, a region that is of the base 102 and in which the power component 101 is disposed is always in contact with the refrigerant. In some possible embodiments, the refrigerant in the first chamber 1022 may alternatively be different from the refrigerant in the second chamber 501, provided that heat dissipation can be implemented for the power module 1 through cycling of the refrigerant between the first chamber 1022, the second chamber 501, and the condenser 2.

In a possible embodiment of this application, a volume of the second chamber 501 may be greater than a volume of the first chamber 1022, so that a capacity of the refrigerant in the second chamber 501 is greater than a capacity of the refrigerant in the first chamber 1022. In this way, the refrigerant in the first chamber 1022 is always in a fully filled state. This helps improve efficiency of heat exchange between the power component 101 and the refrigerant, thereby improving the heat dissipation capability of the power module 1.

In this application, a connection manner between the flow nozzle 1026 and the evaporator 5 is not specifically limited. For example, in the embodiment shown in FIG. 7, the flow nozzle 1026 may be directly inserted into the through hole 502. In addition, the flow nozzle 1026 may be fastened to the evaporator 5 through welding, bonding, or the like, but this is not limited. To ensure sealing between the flow nozzle 1026 and the through hole 502, a sealing ring may be further disposed between the flow nozzle 1026 and the through hole 502. A material of the sealing ring may be but is not limited to rubber. When the sealing ring is specifically disposed, the sealing ring may be sleeved on the flow nozzle 1026, so that when the flow nozzle 1026 is inserted into the through hole 502, the sealing ring is pressed by a sidewall of the through hole 502. In this way, the sealing ring fills a gap between the flow nozzle 1026 and the through hole 502, to implement sealing.

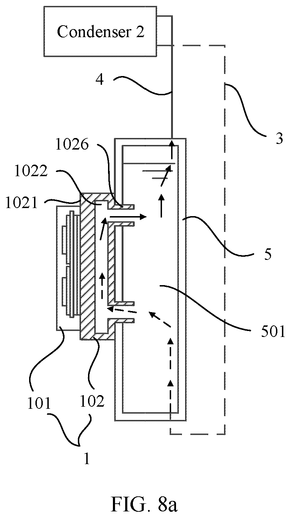

FIG. 8a is a diagram of a heat dissipation principle of the heat dissipation system shown in FIG. 6. In this application, the second chamber 501 of the evaporator 5 may communicate with the condenser 2. During specific implementation, the evaporator 5 and the condenser 2 may be connected through a pipeline, for example, through at least one first gas flowing pipeline 4 and at least one first liquid flowing pipeline 3, so that a gas flowing path and a liquid flowing path can be distinguished.

In FIG. 8a, a solid line with an arrow represents a flowing direction of the gaseous refrigerant, and a dashed line with an arrow represents a flowing direction of the liquid refrigerant. According to the heat dissipation system shown in FIG. 8a, when the power module 1 works, the heat may be conducted from the power component 101 to the first surface 1021 of the base 102, and may be further conducted to the liquid refrigerant in the first chamber 1022 of the base 102. The liquid refrigerant is heated and boils, and forms vapor. The vapor enters the second chamber 501 of the evaporator 5 through the flow nozzle 1026, and enters the condenser 2 through the first gas flowing pipeline 4. After the vapor is condensed into the liquid state in the condenser 2, the vapor may flow back to the second chamber 501 through the first liquid flowing pipeline 3. It may be understood that, after the refrigerant in the first chamber 1022 forms the vapor, the refrigerant in the second chamber 501 may be replenished to the first chamber 1022 in time, so that the refrigerant efficiently cycles between the power module 1, the evaporator 5, and the condenser 2. In this way, heat dissipation is implemented for the power module 1 through phase-change heat exchange of the refrigerant. This helps improve the heat dissipation capability of the power module 1.

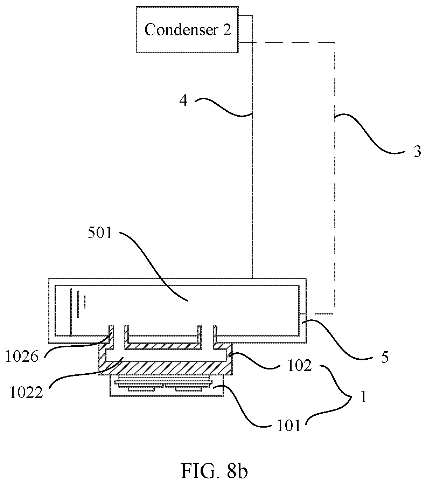

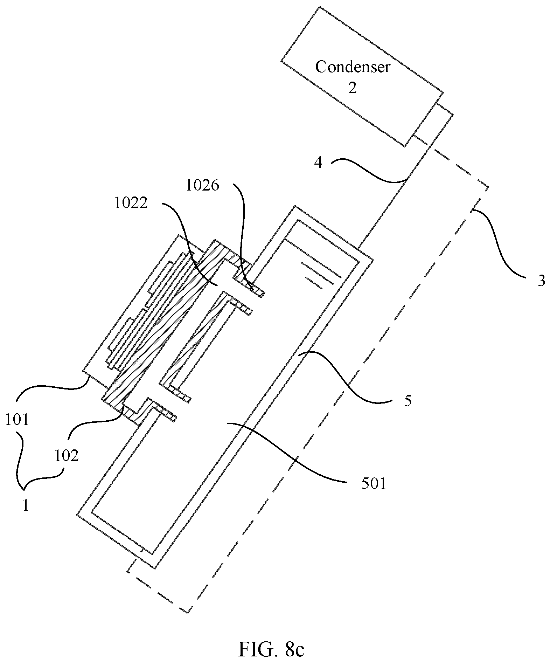

In this application, to enable the refrigerant in the second chamber 501 to be replenished to the first chamber 1022 in time, a liquid level of the refrigerant in the second chamber 501 may be above a liquid level of the refrigerant in the first chamber 1022 in the gravity direction. In addition, to enable the refrigerant condensed into the liquid state by the condenser 2 to flow back to the second chamber 501, the condenser 2 and the evaporator 5 may be arranged in a gravity direction. For example, in the gravity direction, the condenser 2 may be located above the evaporator 5. The condenser 2 and the evaporator 5 may be arranged along a straight line in the gravity direction, or may be staggered in the gravity direction. In addition, the evaporator 5 and the condenser 2 each may be disposed in any direction, and may be adjusted based on a specific application scenario. This is not specifically limited in this application, provided that the liquid refrigerant condensed through the condenser 2 can flow back to the second chamber 501. For example, in the embodiment shown in FIG. 8a, the condenser 2 and the evaporator 5 are arranged along the straight line in the gravity direction, and the power module 1 is located on a surface that is of the evaporator 5 and that is parallel to the gravity direction. For another example, in the embodiment shown in FIG. 8b, the condenser 2 and the evaporator 5 are arranged along the straight line in the gravity direction, and the power module 1 is disposed on a surface that is of the evaporator 5 and that faces away from the condenser 2. For still another example, in the embodiment shown in FIG. 8c, the condenser 2 and the evaporator 5 are staggered in the gravity direction, both the condenser 2 and the evaporator 5 are disposed obliquely, and the power module 1 is disposed on an obliquely disposed surface of the evaporator 5.

In addition, in this application, a plurality of power modules 1 may be disposed on each evaporator 5. For example, in the heat dissipation system shown in FIG. 6, six power modules 1 are disposed on one evaporator 5, and the evaporator 5 is connected to one condenser 2. This facilitates an integrated design of the heat dissipation system.

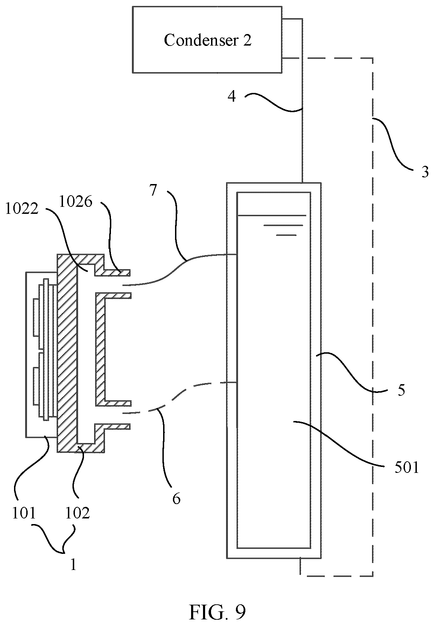

FIG. 9 is a diagram of a structure of another heat dissipation system according to an embodiment of this application. The heat dissipation system shown in FIG. 9 is different from the heat dissipation system shown in FIG. 8a as follows: In FIG. 9, the flow nozzle 1026 of the power module 1 may be connected to the through hole 502 of the evaporator 5 through a pipeline. The pipeline may be a hose, so that the power module 1 and the evaporator 5 are disposed flexibly. In some possible embodiments, the flow nozzle 1026 may alternatively be connected to the evaporator 5 through a rigid pipeline, to improve reliability of the connection between the power module 1 and the evaporator 5.

In the heat dissipation system shown in FIG. 9, at least two flow nozzles 1026 may be disposed on the base 102. In this case, at least one of the flow nozzles 1026 may be connected to the evaporator 5 through a liquid flowing pipeline, and at least one of the flow nozzles 1026 is connected to the evaporator 5 through a gas flowing pipeline. For example, in FIG. 9, a dashed line may represent a second liquid flowing pipeline 6 configured to connect the flow nozzle 1026 and the evaporator 5, and a solid line represents a second gas flowing pipeline 7 configured to connect the flow nozzle 1026 and the evaporator 5. In this way, the vapor formed by the refrigerant enters the second chamber 501 of the evaporator 5 through the at least one flow nozzle 1026 and the second gas flowing pipeline 7, and enters the condenser 2 through the first gas flowing pipeline 4 from the second chamber 501. The liquid refrigerant condensed through the condenser 2 may flow back to the second chamber 501 through the first liquid flowing pipeline 3, and the refrigerant in the second chamber 501 may be replenished to the first chamber 1022 through the at least one flow nozzle 1026 and the second liquid flowing pipeline 6. In this way, the refrigerant efficiently cycles between the power module 1 and the condenser 2. In addition, another structure of the heat dissipation system shown in FIG. 9 may be disposed with reference to FIG. 8a. For example, each evaporator 5 may be connected to at least two power modules 1. Details are not described herein.

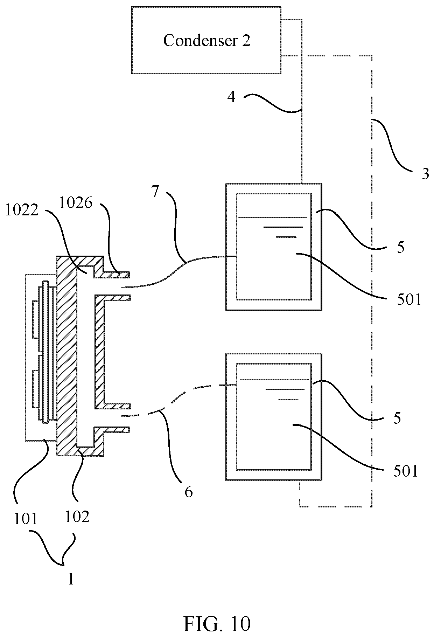

FIG. 10 is a diagram of a structure of another heat dissipation system according to an embodiment of this application. The heat dissipation system shown in FIG. 10 is different from the heat dissipation system shown in FIG. 9 as follows: In FIG. 10, the first chamber 1022 of each power module 1 may communicate with respective second chambers 501 of at least two evaporators 5, and each second chamber 501 is filled with the refrigerant. In addition, in the at least two evaporators 5 connected to the first chamber 1022, at least one of the evaporators 5 is connected to the condenser 2 through the first liquid flowing pipeline 3, and at least one of the evaporators 5 is connected to the condenser 2 through the first gas flowing pipeline 4. In this way, the refrigerant may cycle between the power module 1, the at least one evaporator 5 connected to the condenser 2 through the first liquid flowing pipeline 3, the at least one evaporator 5 connected to the condenser 2 through the first gas flowing pipeline 4, and the condenser 2. Specifically, after the liquid refrigerant in the first chamber 1022 is evaporated into a gas state, the gaseous refrigerant may enter the condenser 2 after passing through the second chamber 501 of the at least one evaporator 5 connected to the condenser 2 through the first gas flowing pipeline 4. The refrigerant condensed into the liquid state by the condenser 2 may flow back to the second chamber 501 of the at least one evaporator 5 connected to the condenser 2 through the first liquid flowing pipeline 3. Refrigerants in the second chambers 501 may be used to replenish the refrigerant in the first chamber 1022.

The at least two flow nozzles 1026 may be disposed on each power module 1. In this way, each flow nozzle 1026 may be connected to at least one evaporator 5. For example, in the heat dissipation system shown in FIG. 10, when a quantity of flow nozzles 1026 is the same as a quantity of evaporators 5, the flow nozzles 1026 may be connected to the evaporators 5 in a one-to-one correspondence. In this embodiment, each power module 1 is connected to the at least two evaporators 5, so that the refrigerant in the first chamber 1022 of the base 102 of the power module 1 can be replenished in time, thereby helping improve heat dissipation efficiency of the power module 1.

Still refer to FIG. 10. In this application, an arrangement manner of the at least two evaporators 5 connected to each power module 1 is not limited. For example, the at least two evaporators 5 may be sequentially arranged in the gravity direction, or may be specifically disposed based on an application scenario of the heat dissipation system. In addition, another structure of the heat dissipation system shown in FIG. 10 may be disposed with reference to FIG. 9. For example, each evaporator 5 may be connected to at least two power modules 1. Details are not described herein.

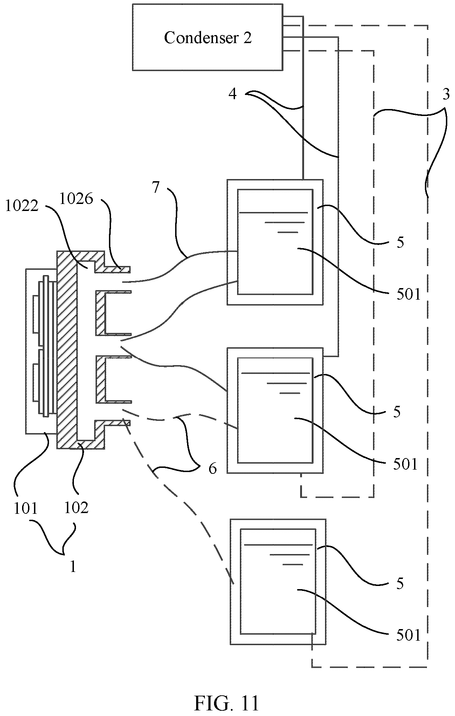

In addition, when the first chamber 1022 of each power module 1 communicates with respective second cavities 501 of at least two evaporators 5, and at least two flow nozzles 1026 are disposed on each power module 1, one flow nozzle 1026 may be further connected to two or more evaporators 5. For example, refer to FIG. 11. FIG. 11 is a diagram of a structure of another heat dissipation system according to an embodiment of this application. In FIG. 11, a connection manner in which one flow nozzle 1026 is connected to two evaporators 5 is shown. In this case, the flow nozzle 1026 may be connected to the two evaporators 5 through the second gas pipeline 7. In addition, the two evaporators 5 are separately connected to the condenser 2 through one first gas pipeline 4. Alternatively, the flow nozzle 1026 may be connected to the two evaporators 5 through the second liquid pipeline 6. In addition, the two evaporators 5 are separately connected to the condenser 2 through one first liquid pipeline 3. Alternatively, the flow nozzle 1026 is connected to one of the two evaporators 5 through the second liquid pipeline 6, and the evaporator 5 may be connected to the condenser 2 through one first liquid pipeline 3. In addition, the flow nozzle 1026 is connected to the other of the two evaporators 5 through the second gas pipeline 7, and the other evaporator 5 is connected to the condenser 2 through one first gas pipeline 4.

In addition, still refer to FIG. 11. In the heat dissipation system shown in FIG. 11, two flow nozzles 1026 may be further connected to one evaporator 5. One of the two flow nozzles 1026 is connected to the condenser 2 through the second liquid flowing pipeline 6, and the other of the two flow nozzles 1026 is connected to the condenser 2 through the second gas flowing pipeline 7. In addition, the evaporator 5 may be connected to the condenser 2 through the at least one first liquid flowing pipeline 3 and the at least one first gas flowing pipeline 4.

In conclusion, the heat dissipation system shown in FIG. 11 at least includes a cycling path of the refrigerant that includes the power module 1, the at least one of the evaporators 5 connected to the condenser 2 through the first liquid flowing pipeline 3, the at least one of the evaporators 5 connected to the condenser 2 through the first gas flowing pipeline 4, and the condenser 2; and a cycling path of the refrigerant that includes the power module 1, at least one evaporator 5 connected to the condenser 2 through the at least one liquid flowing pipeline 3 and the at least one gas flowing pipeline 4, and the condenser 2. Based on this, a connection manner between the power module 1, the evaporator 5, and the condenser 2 is adjusted, so that the heat dissipation system may further include another possible cycling path of the refrigerant. Details are not described herein, but it should be understood that the another possible loop path falls within the protection scope of this application.

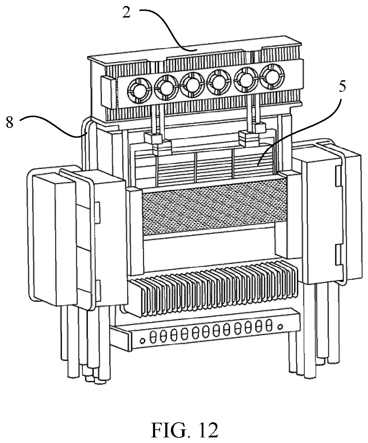

The heat dissipation system provided in this application may be used in various possible power devices. A specific type of the power device is not limited in this application. For example, the power device may be a photovoltaic power generation device like a photovoltaic inverter. FIG. 12 is a diagram of a structure of a possible power device according to an embodiment of this application. In addition to the heat dissipation system, the power device may further include a chassis 8. The evaporator 5 may be located inside the chassis 8 or outside the chassis 8, and the condenser 2 is located outside the chassis 8. The power device has a strong heat dissipation capability, so that product performance of the power device can be improved, thereby improving product competitiveness of the power device.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A heat dissipation system, comprising a power module and a condenser, wherein
the power module comprises a base and a power component, the base has a first chamber, the first chamber is filled with a refrigerant, and the power component is disposed on a first surface of the base; and
the condenser communicates with the first chamber, heat generated by the power component is conducted to the first chamber through the first surface, and the refrigerant in the first chamber enters the condenser after the refrigerant is heated and vaporized, is condensed into a liquid state by the condenser, and flows back to the first chamber.

2. The heat dissipation system according to claim 1, wherein the refrigerant in the first chamber is condensed into the liquid state by the condenser, and flows back to the first chamber under an action of gravity.

3. The heat dissipation system according to claim 1 or 2, wherein when the heat dissipation system is placed in a gravity direction, the condenser is located above the base.

4. The heat dissipation system according to any one of claims 1 to 3, wherein a flow nozzle is disposed on the base, the flow nozzle communicates with the first chamber, and the condenser communicates with the first chamber through the flow nozzle.

5. The heat dissipation system according to claim 4, wherein at least two flow nozzles are disposed on the base, at least one of the flow nozzles is connected to the condenser through a first liquid flowing pipeline, and at least one of the flow nozzles is connected to the condenser through a first gas flowing pipeline.

6. The heat dissipation system according to claim 4, wherein the heat dissipation system further comprises an evaporator, the evaporator has a second chamber, the second chamber is filled with a refrigerant, the second chamber communicates with the first chamber through the flow nozzle, and the second chamber communicates with the condenser.

7. The heat dissipation system according to claim 6, wherein the refrigerant in the second chamber is condensed into a liquid state by the condenser, and flows back to the second chamber under the action of gravity.

8. The heat dissipation system according to claim 6 or 7, wherein when the heat dissipation system is placed in the gravity direction, the condenser is located above the evaporator.

9. The heat dissipation system according to any one of claims 6 to 8, wherein the evaporator is provided with through holes, and flow nozzles are connected to the through holes in a one-to-one correspondence.

10. The heat dissipation system according to claim 9, wherein the flow nozzle is inserted into the corresponding through hole, and the flow nozzle is fastened to the evaporator.

11. The heat dissipation system according to claim 10, wherein a sealing ring is disposed between the flow nozzle and the through hole, the sealing ring is sleeved on the flow nozzle, and a sidewall of the through hole presses the sealing ring.

12. The heat dissipation system according to claim 9, wherein at least two flow nozzles are disposed on the base, at least one of the flow nozzles is connected to the corresponding through hole through a second liquid flowing pipeline, and at least one of the flow nozzles is connected to the corresponding through hole through a second gas flowing pipeline.

13. The heat dissipation system according to any one of claims 6 to 12, wherein the evaporator is connected to the condenser through at least one first liquid flowing pipeline and at least one first gas flowing pipeline.

14. The heat dissipation system according to any one of claims 6 to 12, wherein each first chamber communicates with respective second cavities of at least two evaporators; and
at least one of the evaporators is connected to the condenser through a first liquid flowing pipeline, and at least one of the evaporators is connected to the condenser through a first gas flowing pipeline.

15. The heat dissipation system according to claim 14, wherein at least one evaporator is connected to the condenser through at least one first liquid flowing pipeline and at least one first gas flowing pipeline.

16. The heat dissipation system according to claim 14 or 15, wherein the at least two flow nozzles are disposed on the base of each power module, and each flow nozzle is connected to the at least one evaporator.

17. The heat dissipation system according to any one of claims 4 to 16, wherein the flow nozzle is disposed on a second surface of the base, and the first surface and the second surface are disposed away from each other.

18. The heat dissipation system according to any one of claims 1 to 17, wherein the base has a first inner side surface, the first inner side surface and the first surface are disposed away from each other, and at least a part of the first inner side surface is immersed in the refrigerant.

19. The heat dissipation system according to claim 18, wherein a heat dissipation enhancement structure is disposed on the first inner side surface, and the heat dissipation enhancement structure is disposed in a heat dissipation enhancement region of the first inner side surface, and is configured to increase an area of the first inner side surface immersed in the refrigerant; and in a direction from the first surface to the first inner side surface, at least a part of projection of the power component on the first inner side surface is located in the heat dissipation enhancement region.

20. The heat dissipation system according to claim 19, wherein the heat dissipation enhancement structure is a groove or a protrusion located on the first inner side surface, or the heat dissipation enhancement structure is a fin or a capillary structure disposed on the first inner side surface.

21. A power device, comprising a chassis and the heat dissipation system according to any one of claims 1 to 20, wherein the evaporator is located inside the chassis or outside the chassis, and the condenser is located outside the chassis.
